# EUROPEAN PATENT SPECIFICATION

(11) **EP 1 592 127 B1**
(45) Date of publication and mention of the grant of the patent: **05.11.2008**
(21) Application number: 04425299.7
(22) Date of filing: 29.04.2004
(51) Int. Cl.: H03F 1/32

(54) **Analog predistortion linearizer with fixed in advance intermodulation power, method and device**
Analoger Vorverzerrungslinearisierer mit vorbestimmter Intermodulationsleistung, Verfahren und Vorrichtung
Linéariseur à prédistortion analogique avec puissance d'intermodulation fixée en avance, procédé et dispositif

(43) Date of publication of application: 02.11.2005
(73) Proprietor: Nokia Siemens Networks S.p.A., 20060 Cassina de'Pecchi (MI) (IT)
(72) Inventor: Buoli, Carlo, 20060 Bussero (IT); Erbisti, Luca Oreste, 24047 Treviglio (IT); Fusi, Simone, 21042 Caronno Pertusella (VA) (IT); Turillo, Tommaso, 20063 Cernusco Sul Naviglio (MI) (IT)
(74) Representative: Weidel, Gottfried

(56) References cited:
- EP-A- 0 676 098
- US-A- 4 532 477
- US-B1- 6 316 983

## Description

### FIELD OF THE INVENTION

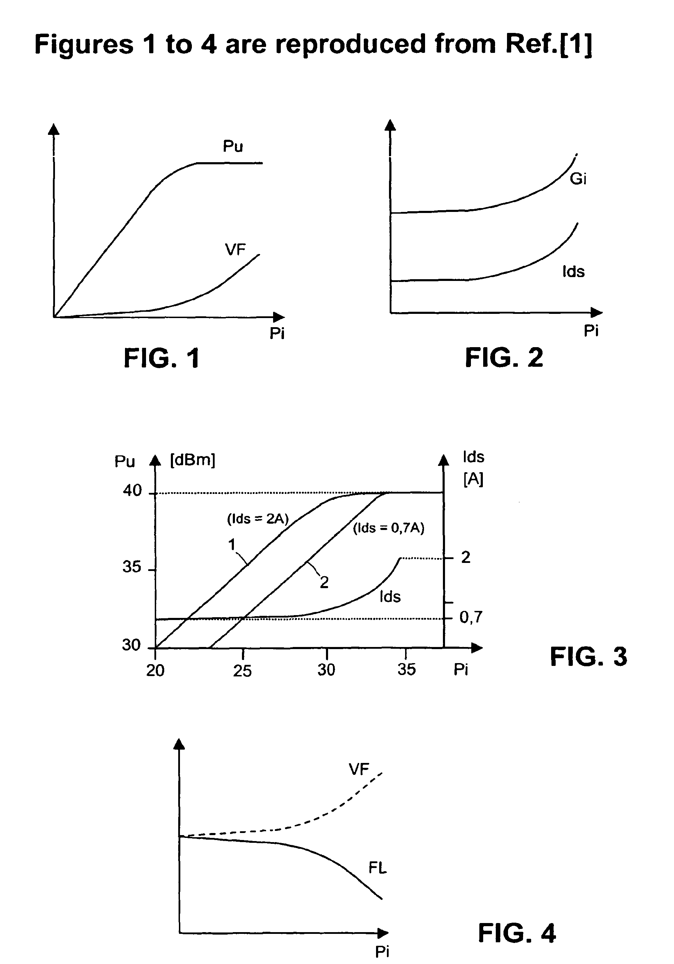

The present invention relates to the field of linear amplification of signals, and more precisely to an analog predistortion linearizer with fixed in advance intermodulation power. Both method and device are concerned with the invention. A predistortion linearizer is a gender of device aimed to correct the defects of a final power amplifier in its task of reproducing the exact shape of the original signal but at higher power level, this means reproducing the exact amplitude and reciprocal phase offset among the various spectral components of the signal. As known, power amplifiers are devices intrinsically non linear at the highest values of amplification where AM-AM and AM-PM distortions are unavoidably generated. Indeed the amplitude and phase response curves of a microwave power amplifier are typically reproduced in **fig.1** wherein is shown the qualitative shape of the output power Pu (AM/AM distortion curve) and the input-output phase VF (AM/PM conversion curve) as a function of the input power Pi. The derivative of the AM/AM curve with respect to Pi generate another curve representing the gain. This one is a significant parameter for testing the linearity of the amplifier, namely: as more it is constant, more the amplifier behaves linearly. As shown in the figure, the gain of the active device is subject to saturation in correspondence of a knee of the curve Pu, also corresponding on the curve VF to a faster increase of the input-output phase offset.

Independently of the modulation of the signal to be amplified is linear or not, linear amplification is mandatory in professional applications characterized by high PMPR (peak-to-mean-envelope-power ratio) e.g.: M-QAM, OFDM, MC-DDMA, DAB, DMT, etc. which require a wide linear region of the amplifier in order to avoid distortions of the signal waveform on the peaks. The amount (dB) by which the average output power is reduced from the saturation power in order to preserve the linearity is commonly named OBO (output backoff). Large OBO due to high PMPR clearly demonstrates inefficient usage of the available output power (if not otherwise provided). A predistortion linearizer device extends the linear dynamic range of the curves Pu and VF, reducing the OBO consequently. In order to achieve this result the linearizer must expand its own gain in the region of the knee in order to continue the linear shape of Pu (fig.1) even in the immediate proximity of saturation, this latter zone being indicated by a horizontal shape which however cannot be compensated; secondly the linearizer must vary its own input-output phase offset in a manner opposite to the shape of VF (fig.1).

Without limitation, some exemplar embodiments of the invention will be described preferably for digital radio applications such as radio links adopting various M-QAM schemes with increasing complexity (higher M) as the transport capacity of the link increases. This restriction is only due to the specific field-of-interest of the Applicant and shall not be considered as a bar for other types of application of the invention every time that high fidelity amplification is needed. Many technical sectors may be concerned with this requirement, because an amplification stage is almost always necessary at the output of the various transducers of physical into electrical signals (e.g.: pressure, velocity, acceleration, light, strengths, etc.). Sound amplification for either live music or recorded reproduction is a clear example. It is in fact well-known that an audio amplifier distorts at the highest volumes, so any means able to avoid this drawback is welcomed. Whether a signal need not to be transmitted also modulation of a carrier with that signal is generally unnecessary, still remaining the requirement of amplify the signal linearly; with that the present invention also applies to baseband signals although from now onward only modulated carriers will be considered.

M-QAM modulations are described by constellations of symbols representing all possible combinations at a symbol time of the module and the phase of a modulation vector. M-QAM are preferred for their good spectral efficiency. Traditional way to achieve QAM modulations is that of using two amplitude modulators to set the components of the modulation vector along two Cartesian axes named In-phase (axis X) and in-Quadrature (axis Y) which are summed up obtaining a modulated carrier to be frequency translated at RF and power amplified for its transmission through the antenna. In order to achieve correct demodulation the amplitude of the I-Q components shall be received as far as possible undistorted also on the peaks of the high PMPRs constellations. Achieving the maximum linearity of the RF finals is a must for QAM, being the linearity a requirement of international standards (i.e. ETSI) introducing mask restrictions for the out-of-band transmitted power and the BER at the receiver. Accordingly, power amplifiers must have better amplitude and phase linearity than those for use with constant envelope modulations at parity of output power, such as CPM and the like even used in digital radio. This also implies greater power consumption for QAM due to the need of adopting less efficient class A or AB bias than the usual class C only suitable for constant envelope. For the above reasons, also considering the increased complexity of the bias circuits and better precision of the active devices, linear amplifiers are generally costly so that an efficient use of them is felt.

### BACKGROUND ART

The efficiency of linear amplifiers can be improved by the application of known linearization methods classifiable as: feed forward, digital predistortion with or without feedback, or analogue RF signal predistortion. Analog predistortion offers several advantages in comparison to the other methods due to circuital simplicity and low power consumption, but it can have many disadvantages:
- Parasitic effects due the heavy tuning can introduce additional unwanted phase/amplitude distortion.
- Temperature affects the linearization characteristics; for this reason compensation circuits are needed.
- When the linearizer is designed at RF frequency there is a tradeoff between performances, bandwidth and high frequency components cost.
- When the linearizer is designed at IF frequency, gain variations in line-up to the power final stage introduce mismatch between the linearizer predistortion characteristics and the distortion of the final stage.
- Tuning of linearizer is needed due the spreading in PA characteristics.

An example of analog predistorter which suffers of the above limitations is disclosed in the European patent EP 0451909 B1 granted in the name of the same Applicant and indicated as **Ref.[1].** Claim 1 of the cited patent recites: "Predistortion linearizer for a final microwave power amplifier which is subjected to gain compression and phase distortion comprising:
- a subpolarized transistor which constitutes a gain expander stage as the power of the signal at its input is increasing, for the complete recovery of said gain compression before saturation;
- a phase shifter controlled by the DC component of the output voltage of said transistor, and introducing a phase distortion which completely offset that of said power amplifier before saturation.

The transistor is preferably a GaAsFET which can be used either as microwave self-linearizing power amplifier or only as simple predistorter linearizer placed upstream another amplifier device. In **fig.2****,** reference is made to the predistorter cited at **Ref.[1],** two curves of the power gain Gi and the polarization current Ids (drain-source) versus the input power Pi of the GaAsFET are shown. With reference to **fig. 2****,** it can be noticed the expansion of the gain Gi and the current Ids in correspondence of the saturation zone of **fig.1****.** In **fig. 3****,** also referred to the predistorter cited at **Ref.[1],** two curves of the output power Pu versus the input power Pi for two relevant values of the polarization current Ids are shown. With reference to **fig. 3****,** it can be noticed that the linearity of the final is extended close to the knee by effect of the gain expansion due to the lowest sub-polarization Ids current close to the pinch-off. The corrective effect is well highlighted in the figure were the concavity of the expansion curve is placed below the convexity of the compressed gain. In **fig. 4****,** also referred to the predistorter cited at **Ref.[1],** the two opposite trends of the input-output phase VF (fig.1) and a correction voltage FL generated by the phase shifter are shown.

An attempt to overcome the aforementioned drawbacks of the analogue predistorters is disclosed the European patent EP 0676098 B1 granted in the name of the same Applicant and indicating the same inventors as in **Ref.[1].** This second reference indicated as **Ref.[2]** is referred to a feedback procedure (and the relevant circuit) for adaptively compensating the gain distortion of an amplifier with linearizer, operating on digitally modulated input signals or in any other manner such that the peak-to-average ratio of modulated signal power is constant, i.e. M-QAM. Thus the adaptive procedure finds application to automatically compensate the combined effects of thermal drift and the ageing on the gain curve of a linearized RF amplifier. As soon as the measured peak-to-average power ratio offsets the theoretical value, a correction voltage acts on the polarization parameter of an active device constituting principally the linearizer. In the case of the linearizer of the patent cited at **Ref.[1],** a correction voltage acts in a way to opportunely shift the near-pinch-off sub-polarization point of the GaAsFET used as linearizer.

Although a good degree of recovery from thermal drift and ageing is obtained, the other drawbacks listed for the analog predistortion linearizers substantially remain. Furthermore, the procedure is valid on the narrow condition that the peak-to-average power ratio of the modulated signal is known in advance, but this is possible only in few cases substantially limited to the M-QAM modulations. Even limiting to the only M-QAM case, a difficult again arises in the set of a correction voltage able to match the trend of the gain exactly because of unavoidable mismatching between the pre-set curve and the real trends. Lastly the feedback circuit complicates the design of the linearizer especially when the linearizer is included in the IF stage

### OBJECTS OF THE INVENTION

The main object of the present invention is that to simplify the design of the analog predistorter linearizers with respect to the designs of the prior art, getting the new design rid of:
- the particular allocation of the linearizer either in the IF or RF stage;
- the dependence of the phase from the gain linearization;
- the dependence of a pre-set trend to be matched as a whole;
- the dependence of a predetermined peak-to-average power ratio to be tracked;
- any physical cause acting on the behaviour of the tandem constituted by the predistorter and the power amplifier, e.g.: thermal drift, ageing, environmental conditions, parasitic capacitances or inductances, misalignment of the gain and/or the phase among different channels when they are commutated at the input of the amplifier,
- having need of the presence a feedback compensating network;
- the dependence from either baseband or RF operating range of the power amplifier;
- having need of some tunings to counteract the spreading of the power amplifier characteristics.

Consequent objects of the invention are the indication of a linearizing method and an analog predistortion linearizing device meeting all the above features.

### SUMMARY AND ADVANTAGES OF THE INVENTION

The invention achieves said objects by providing a method for linearizing the input-output transfer characteristic of a power amplifier which is subjected to gain compression and phase distortion at the higher levels of the output signal, as disclosed in the method claims.

According to the method of the invention, the amplitude and the phase of the signal forwarded to the power amplifier are intentionally distorted with opposite behaviour with respect to the corresponding distortion behaviour of the power amplifier, until the power level of the in-band intermodulation products due to said intentional distortion does not surpass a relevant threshold fixed in advance.

Contrarily to the methods of the known art which try to cancel all possible interference without intentional limitation, the method of the invention is differently aimed to cancel a fixed power level of the in-band intermodulation products, not necessarily corresponding to the higher power of the interference. More precisely, if the power level of the intermodulation products of the device to linearize is fortuitously the same of the one introduced for the aim of linearization, a total cancellation is obtained, instead, if the level is different, there will be a partial but effective cancellation. For the aim of the invention a satisfactorily degree of cancellation is enough (for example -45 dB power level). It is proved that once a target predistortion is fixed in advance, the output power of the linearized device can be increased in the best case of 3 dB with respect to the absence of linearization, while in the worst case the increase is 1.5 dB. The price paid in term of leaving some possible distortion uncancelled is largely repaid by the absence of any gender of tuning to adapt to the change of physical parameters, and the additional fact to leave the designer unaware of the type of power transistor used in the amplifier and of the allocation of the amplifier.

Due to the orthogonal behaviour of the amplitude and phase distortions, the in-band intermodulation products sum up vectorially to obtain the constant power distortion used to correct the nonlinear behaviour of the power amplifier. As a consequence might be possible cut out preventively at the linearizer the weights of the due type of distortions which best fit to the distortion signature of the power amplifier known in advance, e.g.: 70% amplitude distortion and 30% phase distortion. This way of operating allows almost total cancellation of the output distortion until the desired fixed value is reached, matching the 3 dB best case.

Other object of the invention is an analog predistortion linearizer circuit placed upstream a power amplifier affected with gain compression and phase distortion at the higher power levels of the output signal, as disclosed in the device claims. According to the invention of device, the linearizer circuit includes:
- a variable phase shifter which receives the input signal and introduces a phase shift proportional to the output voltage of an envelope detector realized by a first FET which also receives the input signal and is biased near pinch-off to obtain the effect of expanding the power gain and increasing the bias current as the power of the input signal increases, and the bias current being controlled in such a way that a first fixed level of relevant in-band distortion is not trespassed;
- a second FET placed downstream said phase shifter, biased near pinch-off to obtain the effect of expanding the power gain and increasing the bias current as the power of its input signal increases, and the bias current being controlled in such a way that a second fixed level of relevant in-band distortion is not trespassed.

Some preferred embodiments of the linearizer of the invention, which can work jointly or separately, are listed below:
- The variable phase shifter is realised with a voltage-controlled variable capacitor (varicap diode) network.
- Amplitude and phase predistorters are independent circuits characterized by low orthogonal distortion interference; this make easier to obtain the best equalizer working point. Considering in fact that phase variation is directly impressed on low level input signal, and that intermodulation products due to the phase distortion unavoidably introduced by the cascaded amplitude predistorter is 20 dB less than the contribute of the amplitude distortion, it can be reasonably consider the independence of the phase from the amplitude distortion.
- The fixed level of predistortion is set by a feedback operational amplifier driven by a reference voltage, absolutely stable in a wide range of temperatures, to set a constant average bias drain current Idss of the FETs. In this way we obtain stability of the linearization with temperature and insensitivity both to pinch-off and Idss spreading among the production lot of the FETs. With that no tuning of the linearization is needed.
- The linearizer works at IF frequency, in this way other than reducing cost of the needed components, may be placed far from the power amplifier, for example indoor and the transmitter outdoor. Moreover the lower IF with respect to RF allows to obtain improvement of the performances.
- The FETs used in the amplitude and phase linearizers are GaAsFETs characterized by a cut off frequency much higher than the operative frequency, this entails low parasitic effects and lower AM/PM residuals to compensate, making no tuning more favourable.
- The linearizer is placed in a constant signal power section. This fact makes the circuit simpler.
- The gain of the linearizer (depending on the working point set by the selected fixed current) is automatically stabilized to a constant value to make the power level in the RF line-up independent of linearizer setting.

The embodiment of all technical features listed above makes the predistortion linearizer of the invention a very useful tool.

### BRIEF DESCRIPTION OF THE DRAWINGS

The features of the present invention which are considered to be novel are set forth with particularity in the appended claims. The invention and its advantages may be understood with reference to the following detailed description of an embodiment thereof taken in conjunction with the accompanying drawings given for purely non-limiting explanatory purposes and wherein:
- **figures 1** to **4****,** already described, show some curves reproduced from **Ref.[1]** ;
- **figures 5** to **7** show some architectural variants of a linearized amplifier according to the present invention;
- **figures 8** and **9****,** show the best and the worst case for the working points of the linearizer of the invention resulting from the vectorial summation of fixed amplitude and phase predistortions;
- **fig.10** shows some logarithmic curves of the in-band 3th order distortion measured at the output of the power amplifier with, and without, the linearizer of the invention, versus the input power of two-carrier test signal;
- **fig.11** shows the gain expander circuit of the invention;
- **fig.12** shows the phase predistorter circuit of the invention;
- **figures 13** and **14****,** show two tone - third order AM/AM and AM/PM distortion curves of the predistortion power versus drain current of the active device (FET) used in the linearizer;
- **fig.15** shows an ideal setting of the gain curves relevant to the gain expander circuit of fig.11;
- **figures 16** and **17****,** show two examples of how get gain stabilization;
- **figures 18** and **19****,** show two gain stabilization circuits which embody the example of the figures 16 and 17, respectively.

### DETAILED DESCRIPTION OF AN EMBODIMENT OF THE INVENTION

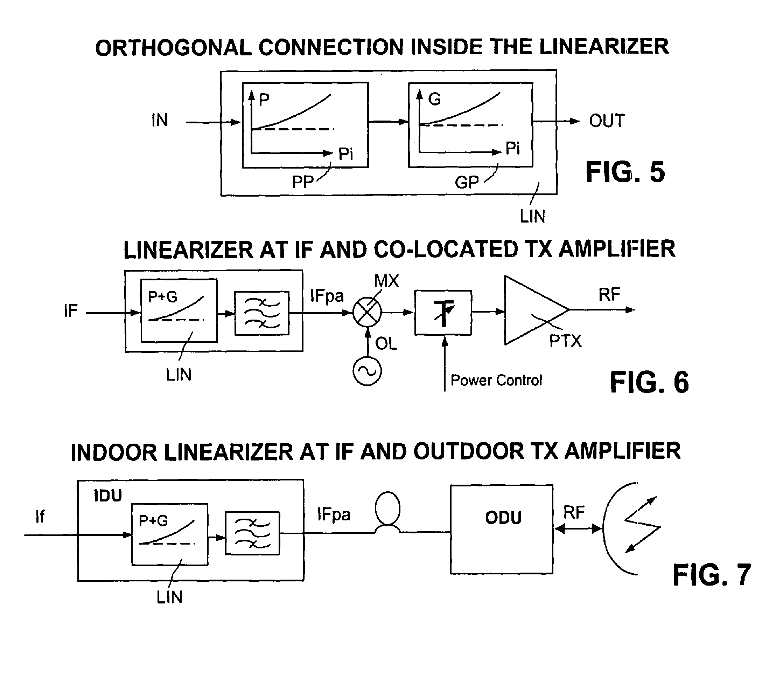

With reference to **fig.5** we see a linearizer LIN including a gain predistorter GP cascaded to a phase predistorter PP. The linearizer LIN accepts an input signal IN at low power level at provides an output signal OUT which is a copy of the input signal IN affected by phase and amplitude distortions. Expansion curves of the gain G and the phase P are shown in correspondence of blocks GP and PP. As said in the introduction, the cascade achieves a satisfactory independent set of the two types of predistortion. As known, a predistortion linearizer is set to obtain opposite distortion behaviour compared to the device to linearize. Without limitation, the latter is considered a power transistor with known distortion behaviour consisting of compression of the gain and expansion of the input-output phase at the highest power levels of the output signal. As a consequence, the amplitude predistorter GP expands the gain to annul the effect of gain compression, and the phase predistorter PP compresses the phase to annul the effect of phase expansion. Other types of active devices (for example TWTs) have different phase distortion behaviour with respect to the power transistors, but also in this case the phase distortion can be cancelled by a linearizer LIN able to introduce in advance phase variations with opposite sign with respect to the ones introduced by the used active device. The effect of amplitude and phase distortion on the output signal can be checked by the spectral analysis of the in-band intermodulation products: two-tones test is currently used at the purpose.

With reference to **fig.6****,** a block diagram of a RF transmitter includes an analog linearizer LIN which accepts a modulated intermediate frequency signal IF and outputs a phase-amplitude predistorted signal IFpa directed to an input of a mixer MX pumped by a local oscillator signal OL to translate at RF the predistorted signal. The predistorted RF signal reaches the input of a variable attenuator T controlled by a power control signal to set a constant average power level at the input of an RF power amplifier PTX. An alternative configuration (not shown in the figure) may include the variable attenuator T inside the IF stage to obtain a constant average power level at the output of the linearizer LIN.

With reference to **fig.7****,** a different solution is represented in which the linearizer LIN is far from the remoted power amplifier. In this case the linearizer is housed in an indoor unit IDU connected to an outdoor unit ODU, including the radiofrequency conversion stage and the transmission power amplifier, by means of physical connection at IF such as coaxial cable.

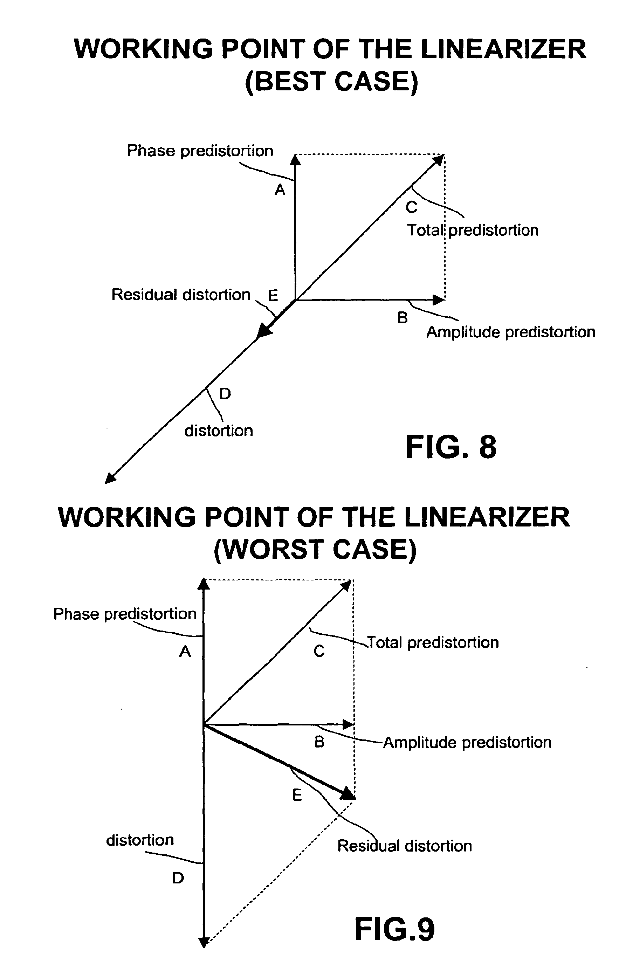

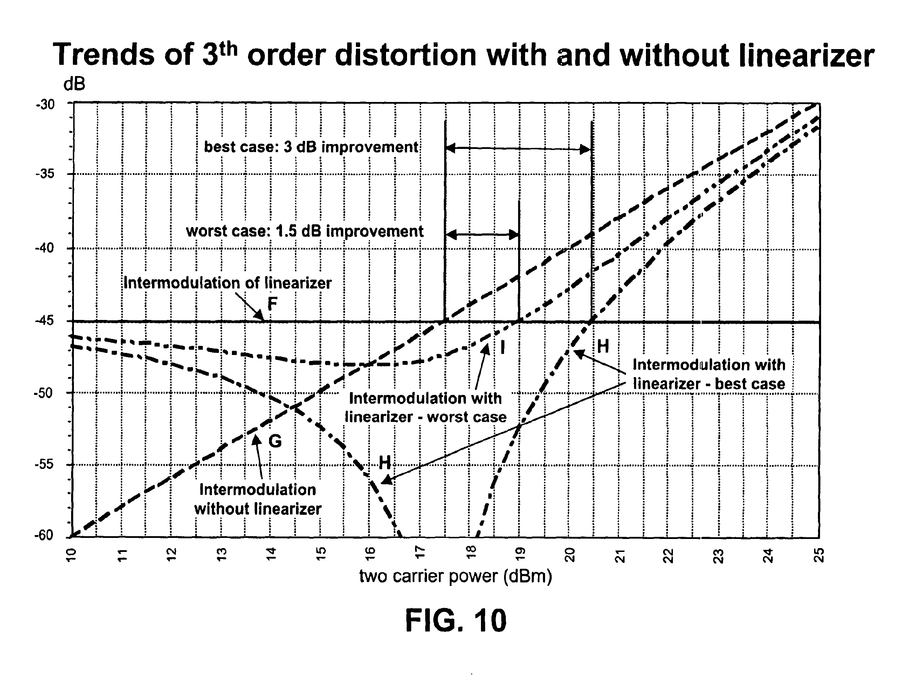

With reference to **fig.8****,** we see two orthogonal vectors A, B respectively associated to the phase and the amplitude predistortion impressed by the linearizer LIN (fig.5). Assuming the most general case of totally unknown behaviour at the linearizer LIN of how the power amplifier PTX (fig.6) is sharing out the phase and the amplitude contributions to the distortion into the overall in-band intermodulation products, equal contributions is assumed. In this case vectors A, B have equal module representing the individual contributions to the overall predistortion. Vectors A, B sum up to give a resulting vector C subtending 45° with the first two, whose module represents the average power level of overall in-band intermodulation products at the output of linearizer LIN. It can be appreciate that assuming, for example, -45 dB the ratio between the module of vector C and the average power level of the modulated IF carrier, the module of each component vector A, B is -48 dB. In **fig.8** a vector D associated to the distortion introduced by the power amplifier is rotated of 180° with respect to the vector C. This represents the best case corresponding to the maximal cancellation of the distortion by effect of the -45 dB predistortion, leaving a residual part of the vector D, corresponding to a vector E, uncancelled. Without the punctual knowledge of the phase/amplitude signature characterizing the power amplifier distorting behaviour, the best case is generally a chance. Assuming as design criterion not to consider the signature, a fair choice is that to subdivide total distortion/predistortion between phase and amplitude equally. This assumption make easier and immediate the selection of the working points of the predistorters PP and GP (fig.5), namely 3 dB below the module of vector C. After which, the worst case which the ideal working point has to face is an interesting knowledge to qualify the design. **Fig.9** shows the worst case corresponding to the one which the power amplifier has either only phase or only amplitude distortion. The vectorial cancellation discussed with reference to **figures 8** and **9** for arbitrary power values of the distortion, is now investigated in **Fig.10** for continuous range of power values; the aim is that to quantify the best and the worst case.

**Fig.10** shows four curves indicated as F, G, H, and I, the ordinate representing the in-band intermodulation product level at the output (in the order) of: linearizer LIN, not linearized power amplifier, linearized power amplifier PTX best case, and linearized power amplifier PTX worst case.. With reference to **Fig.10****,** on the abscissa from 10 to 25 dBm power range of a two-carrier test signal is reported, on the ordinate the curve F of the linearizer LIN is set to a constant value of -45 dB corresponding to the distortion which is subtracted at the output of the power amplifier PTX. It can be noticed that for low output power levels the intermodulation products on the curves G, H, I are always less than the value set on the curve F of the linearizer. Besides, the output power for which the best case curve H of the linearized device is below the curve F of the linearizer increases of 3 dB in comparison with the curve G of a non linearized device. The same considerations applied to the worst case curve J of the linearized device show an increase of only 1.5 dB. In conclusion, according to the linearization method of the invention, once maximum acceptable intermodulation products level is defined, it's possible to set the linearizer at this level to obtain 1.5 to 3 dB power gain of the linearized device, automatically.

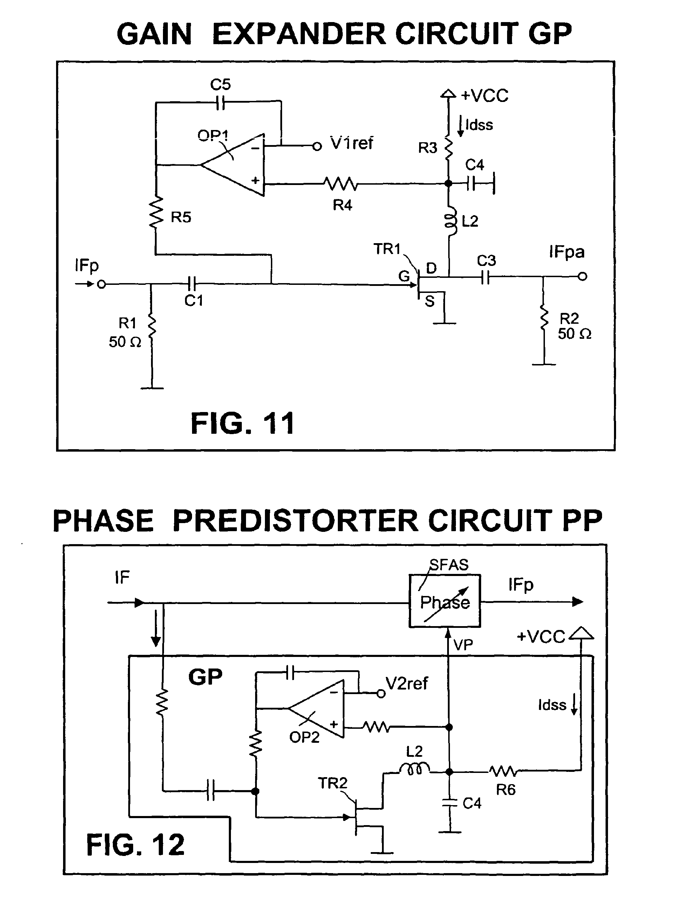

**Fig.11** shows a circuital embodiment of the amplitude predistorter GP of **fig.5****,** implemented with a FET TR1, a differential amplifier OP1, and some passive elements. The predistortion linearizer is designed to operate at intermediate frequency, nevertheless TR1 is a microwave GaAsFET used in common source configuration. With the exception of the operational amplifier OP1 and its resistive network, the represented circuit is similar to the one represented either in **Ref. [1]** or **Ref. [2].** More precisely, two 50 Ω resistors R1 and R2 across the input and the output ports of the linearizer constitute the characteristic impedances seen at those ports. Capacitor C1 couples the input signal IFp to the gate of TR1, blocking the DC current, similarly capacitor C3 couples the output signal IFpa present at the drain of TR1 to the output port of the linearizer, blocking the DC current. The source of TR1 is connected to ground. The drain is connected to the biasing voltage +VCC through a low pass filter L2, C4 interposed between the drain and a resistor R3 connected to the biasing terminal. The terminal of R3 connected between L2 and C3 is further connected to a resistor R4 in its turn connected to a first input of OP1, the other input of OP1 is connected to a device (not visible) which supplies a voltage reference V1 ref absolutely stable inside a wide range of temperatures. Similar devices are easily available in commerce at low cost. The output of OP1 is connected to a resistor R5 further connected to the gate of TR1.

In operation, Low pass filter L2, C4 stops output signal IFpa towards the bias terminal and the input of OP1. The operational amplifier OP1 plus C5 constitute a differential integrator slow enough to be insensitive to the modulation but only sensitive to the average bias current in TR1. The biasing drain current Idss through the resistor R3 is determined by the feedback action of the operational amplifier OP1 which controls the gate of TR1 in order to set a constant d.d.p. |VCC - V1ref| across R3 and hence a constant Idss = |VCC - V1ref|/R3 current. The bias current Idss keep the FET TR1 subpolarized in the pinch-off region, so that an increase of the input signal IF causes a gain expansion of TR1 by effect of autopolarization. Considering that the power level of the intermodulation products at the output of TR1 is only function of the set current Idss and the power of input signal IF, from the above considerations it results that said power level is independent of temperature, pinch-off voltage and Idss spreading. For this reason the tuning of the circuit to compensate for the derive of the gain expansion can be avoided.

**Fig.12** shows a circuital embodiment of the phase predistorter PP of **fig.5****,** implemented with a variable phase shifter SFAS and a envelope detector GP2 almost equal to the amplitude predistorter of **fig.11****.** The two blocks SFAS and GP2 receive at the input the intermediate frequency signal IF, the envelope detector GP2 outputs a phase control voltage VP directed to a control input of block SFAS; the latter shifts the phase of the input signal IF according to the control voltage VP, and outputs a signal IFp with an amount of phase predistortion which depends on voltage VP. This voltage is taken on the drain of FET TR2 internal to block GP2, which operates as amplitude detector biased with fixed Idss current. The high frequency components on the drain of TR2 are suppressed by the low pass filter L2, C4, so as voltage VP is free to follow the baseband modulation and hence the gain expansion of the FET on the peaks of modulation. The gain expansion of FET TR2 is reflected into a corresponding compression of voltage VP on the drain, which is translated into a corresponding nonlinear phase variation of the input signal IF leaving undistorted its amplitude. This behaviour is perfectly in agreement with the curves **of** **fig.4****,** which shows the expansion trend of the phase VF introduced by the power amplifier and the compression trend of the correction voltage FL (now VP) generated by the phase shifter (block PP). Voltage VP both depends on the amplitude of input signal IF and the point of work (Vdss, Idss) of FET TR2. The latter is kept constant by OP2 which sets the constant value of Idss tied to the voltage reference V2ref and the value of resistance R6. Wit that no tuning also applies to the phase predistortion.

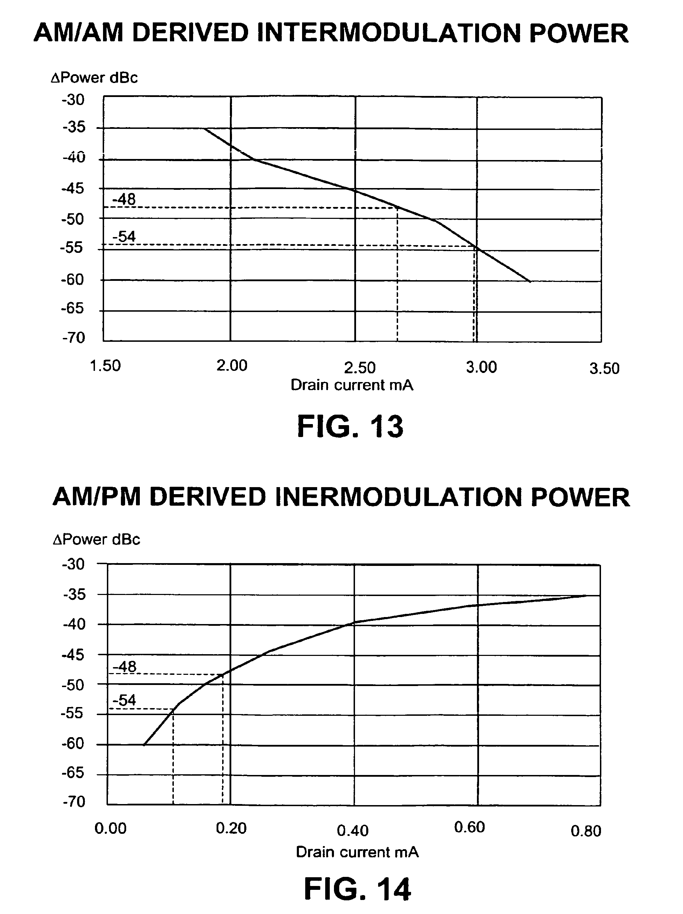

**Fig.13** shows a power level curve of the AM/AM in-band two-tone intermodulation products versus drain current measured at the output of FET TR1 (mgf1908 - fig. 11) with two-tone input signal. **Fig.14** shows a power level curve of the AM/PM in-band intermodulation products versus drain current measured at the output of phase shifter SFAS controlled by FET TR1 (mgf1908 - fig.12) with two-tone input signal. With reference to all the **figures** from **5** to **14,** intermediate frequency signal IF (hence IFp and IFpa) is a 1.690 GHz sinusoid M-QAM modulated (M = 16, 32, 64, 128) with 56 MHz bandwidth. The average input level is -5 dBm subject to increase on the level peaks depending on the modulation and the filter roll-of, e.g.: near 6 dB for 16-QAM and 8-10 dB for 128-QAM. Two opposite distortion trends are visible in **figures 13** and **14****,** namely in **fig.13** the AM/AM distortion is decreasing with the increase of the drain current wile in **fig.14** the AM/PM distortion is increasing. The explanation of the opposite trends is that although the two FETs are polarized near pinch-off, in AM/AM the FET, having higher bias current, is nearer to the linear region and behave more linear when the current increase while in AM/PM the FET is very far from the linear region, and an increase of current increases his efficiency as a detector. A common characteristic of the two curves is their rapid dynamic near pinch-off, corresponding to the left-side zone. The misalignment between the scales of drain current values is due to the fact that phase variations depend on the control voltage of the varicap diode inside block SFAS and the more suitable value of the voltage VP is obtained nearer to the pinch-off.

As a consequence of the opposite trends, different current values are selected on the two curves in correspondence of a same amount of distortion. Remind the attention to the arguments developed with reference to **fig.8****,** two working points of -48 dBc are indicated on the two curves of **figures 13** and **14****.** Assuming the case of 16-QAM modulation with PMPR of 6 dB, the average power level of -54 dBc is also indicated on the two curves. In correspondence of -54 dBc the bias drain currents of almost 3 mA and 107 µA result for AM/AM and AM/PM, respectively. The relevant polarisation networks and the voltage references V1 ref and V2ref shall be set accordingly.

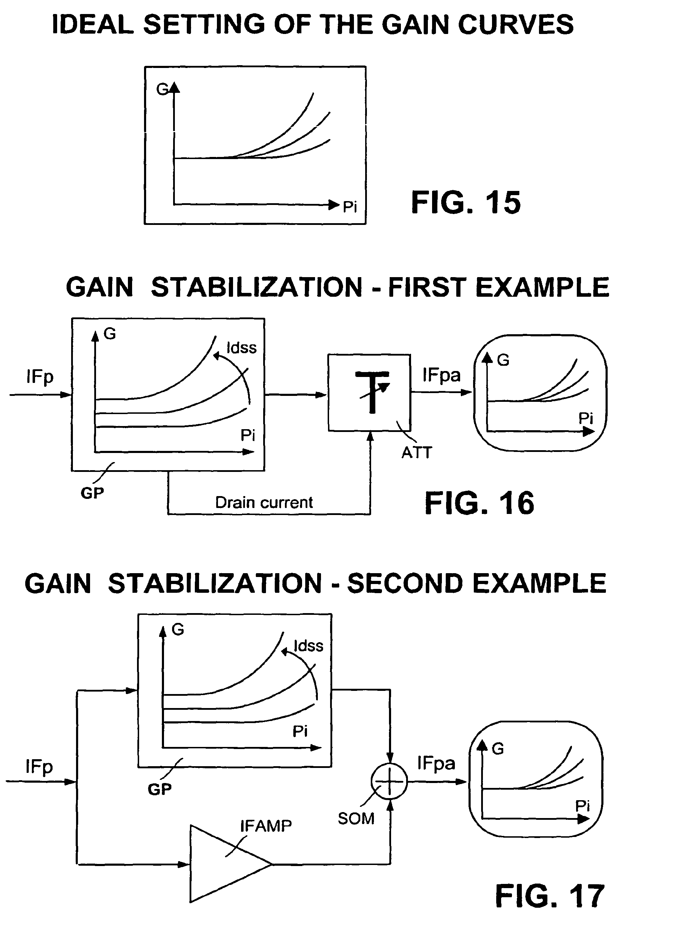

**Fig.15** shows a diagram of different gain expansion curves versus input power Pi as should be requested to an amplitude predistorter to let the designer free of selecting a gain curve leaving the initial (unexpanded) constant gain unchanged. With reference to **fig.15****,** the different expansion curves converge to the same level for low values of Pi; this makes the design of the IF/RF line-up independent of the presence of the linearizer. Contrarily to this requirement, the amplitude predistorter GP of **fig.11** has initial constant gain dependent from the drain current Idss set in advance, so that a further mechanism to stabilize the gain is requested.

**Fig.16** shows a first example of how stabilizing the gain of TR1 (fig.11) by means of a variable attenuator ATT put in cascade to the amplitude predistorter GP and controlled by the drain current of TR1 to pursue the stabilization. The attenuator ATT is profitably obtained by DC current-controlled pin diodes. Left in the figure the amplitude predistorter GP is schematised by a family of gain versus Pi curves with the biasing drain current Idss as parameter. Contrarily to the representation of fig.15, the curves don't converge for low values of Pi. This gain variation has to be compensated because the final power amplifier need a definite input power, independently from the set predistortion. An automatic compensation included in the predistorter permits to work with constant power before and after the predistorter. Right in the figure the effect of automatic compensation is visible on an ideal display.

**Fig.17** shows a second example of how stabilizing the gain of the expansion FET. With reference to **fig.17****,** the input signal IFp is split and forwarded along two branches: a first one including the amplitude predistorter GP, the second one including a linear preamplifier IFAMP which does not distort the signal; the output signals from the two amplifiers are summed up by an analog adder SOM to obtain the predistorted signal IFpa. The gain stabilization is now obtained adding undistorted signal to the distorted one through a parallel path. In this configuration the linearizer needs a greater level of expansion to obtain the same intermodulation products level at the output.

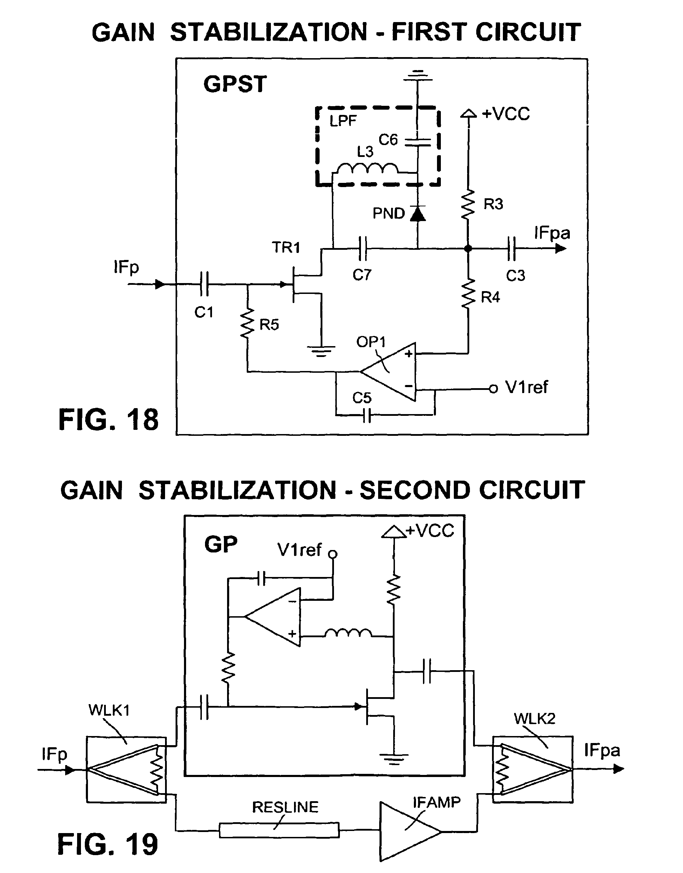

**Figures 18** and **19** depict possible circuital embodiments of the examples of **figures 16** and **17****.** **Fig.18** shows an amplitude predistorter GPST which differs from GP of fig.11 mainly by the introduction of a pin diode PND in series to R3, by a different connection of the low pass filter L3, C6 highlighted inside dashed marked block LPF, and by the insertion of a capacitor C5 between the drain of TR1 and the anode of PND. In operation, the biasing Idss current flows trough the resistor R3, the pin diode PND, and the inductance L3 before reaching the drain of TR1. Capacitor C7 couples the modulated signal IFpa present at the output of TR1 to the anode of diode PND, while capacitor C6 connect the cathode of PND to ground, so that diode PND is crossed by the direct-component of the signal current other than the ldss current flowing through R3. To summarize, the current flowing through the pin diode PND is equal to the mean drain current in TR1: when the current increases the FET gain increases but also the pin diode attenuation, in this way the gain is stabilized. The cut-off frequency of low pass filter LPF is much lower than the modulation frequency bandwidth, in this way the average power gain doesn't depend on modulation.

**Fig.19** shows an example where signal splifting/adding function of the example of **fig.17** is implemented with Wilkinson couplers respectively indicated as WLK1, WLK2. Along the parallel path a delay line RESLINE is inserted in series to the amplitude IFAMP to compensate the delay between the two branches before the two signals are summed up at the output of WLK2. This makes it possible to reach a minimum orthogonal residual distortion (AM/PM effect). Furthermore the delay line RESLINE can be a resistive line acting as attenuator to vary the level of the parallel path, trading off between the gain stabilization and the maximum possible equalization. If not using a resistive line an attenuator has to be inserted before or after RESLINE to obtain the said trading off.

## Claims

1. Method for linearizing the input-output transfer characteristic of a signal power amplifier (PTX) affected with amplitude and/or phase distortion at the higher power levels of the output signal, by introducing on the signal to be amplified an analog predistortion of the phase (PP) and the amplitude (GP) with opposite trend with respect to said distortion impressed by the power amplifier, **characterized in that:** it includes the steps of:
- setting a fixed value of maximum phase predistortion (A) from a maximum fixed-a-priori power level (C) of the in-band intermodulation products introduced by both the phase and amplitude predistortions;
- setting a fixed value of maximum amplitude predistortion (B) as in the previous step;
- performing phase predistortion until the extent of the corresponding setting;
- performing amplitude predistortion until the extent of the corresponding setting.

2. The method of claim 1, **characterized in that** said maximum fixed-a-priori power level (C) of the in-band intermodulation products is subdivided into two contributes respectively corresponding to said fixed value of maximum phase predistortion (A) and amplitude predistortion (B).

3. The method of claim 2, **characterized in that** said contributes are equal.

4. The method of claim 2, **characterized in that** said contributes are selected to match the signature distortion of the power amplifier (PTX).

5. The method of any preceding claim, **characterized in that** the signal amplified by sad power amplifier (PTX) is a baseband signal generated by a transducer, for example a microphone.

6. The method of any preceding claim except 5, **characterized in that** the amplified by sad power amplifier (PTX) is a modulated radiofrequency carrier (RF), for example an M-QAM signal with given peak-to-average power ratio depending on M.

7. The method of claim 6, **characterized in that** the intermediate frequency signal (IF) is predistorted indoor (IDU) and conveyed to a radiofrequency conversion and power amplification stage located outdoor (ODU) through a physical connection.

8. Analog predistortion linearizer (LIN) to be connected upstream a power amplifier (PTX) affected with gain compression and phase distortion at higher power levels of the output signal (RF), including a phase predistorter (PP) and an amplitude predistorter (GP) controlled so as to introduce phase and amplitude predistortions at higher power levels of the input signal (IN, IF) with opposite directions with respect to the ones introduced by the power amplifier (OUT, RF), **characterized in that:**
- the phase predistorter (PP) is placed upstream the amplitude predistorter (GP);
- the phase predistorter (PP) includes first setting means (OP2, R6, V2ref) arranged to set a fixed value of maximum phase predistortion (A) on the signal (IFp) forwarded to the amplitude predistorter (GP);
- the amplitude predistorter (GP) includes second setting means (OP1, R3, V1ref) arranged to set a fixed value of maximum amplitude predistortion (B) on the signal (IFpa) forwarded to the power amplifier (PTX);
- both the first and second setting means are configured (V2ref, V1ref) so as to derive their setting (A, B) from a maximum fixed-a-priori power level (C) of the in-band intermodulation products introduced by both the phase and amplitude predistorters (PP, GP).

9. The analog predistortion linearizer of claim 8, **characterized in that** the control means of said phase predistorter (PP) include:
- a voltage-controlled phase shifter (SFAS);
- an envelope detector (GP2) for outputting the control voltage (VP) for the phase shifter (SFAS) controlled in its turn by said low level input signal (IF, IN) so as to introduce control voltage (VP) distorted with opposite direction with respect to the phase distortion introduced by the power amplifier (PTX);
- the envelope detector (GP2) includes the first setting means (OP2, R6, V2ref) arranged for not trespassing a fixed value of predistortion on the control voltage (VP) corresponding to said fixed value of phase predistortion (A).

10. The analog predistortion linearizer of the preceding claim, **characterized in that** said amplitude predistorter (GP) and said envelope detector (GP2) each includes a FET (TR1, TR2) subpolarized at pinch-off so as to expand the gain and increase the bias current by effect of autopolarization as the power level of the relevant input signal increases.

11. The analog predistortion linearizer of the preceding claim, **characterized in that** said FET has a cut-off frequency much higher than the operative frequency.

12. The analog predistortion linearizer of any claim from 8 to 11, **characterized in that** said first and second setting means each includes an operational amplifier arranged within a feedback configuration to set a constant average bias drain current (Idss) of said FET only depending of an individual reference voltage (Vref2, Vref1) applied to an input of the operational amplifier, said reference being stable into a wide range of temperatures.

13. The analog predistortion linearizer of any claim from 10 to 12, **characterized in that** a variable attenuator (ATT) is cascaded to said amplitude predistorter (GP) to set an attenuation directly depending on the undistorted gain of the FET.

14. The analog predistortion linearizer of the preceding claim, **characterized in that** the variable attenuator (ATT) is a pin diode crossed by the direct component of the drain current of the FET.

15. The analog predistortion linearizer of any claim from 8 to 14, **characterized in that** includes:
- means (WLK1) to split up the input signal (IFp) into a copy of signals at the input of two parallel branches, a first of which including said amplitude predistorter (GP) and the relevant control and setting means;
- a linear power amplifier (IFAMP) along the second branch;
- delay means (RESLINE) along the second branch to equalize the delays at the output of the two branches;
- means (WLK2) to sum up the signals at the output of the two branches obtaining an unique predistorted signal (IFpa) forwarded to the power amplifier (PTX).

16. The analog predistortion linearizer of the preceding claim, **characterized in that** said delay means (RESLINE) are constituted by a resistive line acting as attenuator to vary the signal level on the parallel branch.

17. The analog predistortion linearizer of the claim 15, **characterized in that** an attenuator is connected in series to said delay means (RESLINE) to vary the signal level on the parallel branch.

## Patentansprüche

1. Verfahren zum Linearisieren der Eingangs-/Ausgangs-Übertragungskennlinie eines durch Amplituden- und/oder Phasenverzerrung auf den höheren Leistungspegeln des Ausgangssignals beeinflußten Signal-Leistungsverstärkers (PTX) durch Einführen in das zu verstärkende Signal einer Analog-Vorverzerrung der Phase (PP) und der Amplitude (GP) mit entgegengesetzter Tendenz zu der durch den Leistungsverstärker auferlegten Verzerrung, **dadurch gekennzeichnet, daß** es folgende Schritte umfaßt:
- Einstellen eines festen Wertes maximaler Phasenvorverzerrung (A) von einem maximalen vorbestimmten Leistungspegel (C) der durch sowohl die Phasen- als auch Amplitudenvorverzerrungen eingeführten Inband-Intermodulationsprodukte;
- Einstellen eines festen Wertes maximaler Amplitudenvorverzerrung (B) wie im vorhergehenden Schritt;
- Durchführen von Phasenvorverzerrung bis zum Ausmaß der entsprechenden Einstellung;
- Durchführen von Amplitudenvorverzerrung bis zum Ausmaß der entsprechenden Einstellung.

2. Verfahren nach Anspruch 1, **dadurch gekennzeichnet, daß** dieser maximale vorbestimmte Leistungspegel (C) der Inband-Intermodulationsprodukte in zwei jeweils dem festen Wert maximaler Phasenvorverzerrung (A) und Amplitudenvorverzerrung (B) entsprechende Beiträge unterteilt wird.

3. Verfahren nach Anspruch 2, **dadurch gekennzeichnet, daß** diese Beiträge gleich sind.

4. Verfahren nach Anspruch 2, **dadurch gekennzeichnet, daß** diese Beiträge so ausgewählt sind, daß sie der Signaturverzerrung des Leistungsverstärkers (PTX) entsprechen.

5. Verfahren nach einem beliebigen vorhergehenden Anspruch, **dadurch gekennzeichnet, daß** das durch den Leistungsverstärker (PTX) verstärkte Signal ein durch einen Wandler, beispielsweise ein Mikrofon, erzeugtes Basisbandsignal ist.

6. Verfahren nach einem beliebigen vorhergehenden Anspruch außer 5, **dadurch gekennzeichnet, daß** das durch den Leistungsverstärker (PTX) verstärkte Signal ein modulierter Hochfrequenzträger (HF), beispielsweise ein M-QAM-Signal mit einem gegebenen Spitze-Durchschnittswert-Leistungsverhältnis in Abhängigkeit von M ist.

7. Verfahren nach Anspruch 6, **dadurch gekennzeichnet, daß** das Zwischenfrequenzsignal (ZF) im Haus (IDU) vorverzerrt und durch eine physikalische Verbindung zu einer außer Haus (ODU) befindlichen Hochfrequenz-Wandlungs- und Leistungsverstärkungsstufe übermittelt wird.

8. Stromaufwärts eines durch Verstärkungskompression und Phasenverzerrung auf höheren Leistungspegeln des Ausgangssignals (HF) beeinflußten Leistungsverstärkers (PTX) zu verbindender Analog-Vorverzerrungslinearisierer (LIN) mit einem Phasenvorverzerrer (PP) und einem Amplitudenvorverzerrer (GP) zur Einführung von Phasen- und Amplitudenvorverzerrungen auf höheren Leistungspegeln des Eingangssignals (IN, ZF) in entgegengesetzten Richtungen bezüglich der durch den Leistungsverstärker (OUT, HF) eingeführten gesteuert, **dadurch gekennzeichnet, daß:**
- der Phasenvorverzerrer (PP) stromaufwärts des Amplitudenvorverzerrers (GP) plaziert ist;
- der Phasenvorverzerrer (PP) erste Einstellmittel (OP2, R6, V2ref) angeordnet zum Einstellen eines festen Wertes maximaler Phasenvorverzerrung (A) an dem zum Amplitudenvorverzerrer (GP) weitergeleiteten Signal (ZFp) umfaßt;
- der Amplitudenvorverzerrer (GP) zweite Einstellmittel (OP1, R3, V1ref) angeordnet zu Einstellen eines festen Wertes maximaler Amplitudenvorverzerrung (B) an dem zum Leistungsverstärker (PTX) weitergeleiteten Signal (ZFpa) umfaßt;
- sowohl die ersten als auch zweiten Einstellmittel so konfiguriert sind (V2ref, V1ref), daß sie ihre Einstellung (A, B) aus einem maximalen vorbestimmten Leistungspegel (C) der durch sowohl den Phasen- als auch Amplitudenvorverzerrer (PP, GP) eingeführten Inband-Intermodulationsprodukte ableiten.

9. Analog-Vorverzerrungslinearisierer nach Anspruch 8, **dadurch gekennzeichnet, daß** die Steuermittel des Phasenvorverzerrers (PP) folgendes umfassen:
- einen spannungsgeregelten Phasenschieber (SFAS);
- einen Hüllkurvendetektor (GP2) zum Ausgeben der Regelspannung (VP) für den Phasenschieber (SFAS), wiederum durch das schwache Eingangssignal (ZF, IN) gesteuert, um in entgegengesetzter Richtung zu der durch den Leistungsverstärker (PTX) eingeführten Phasenverzerrung verzerrte Regelspannung (VP) einzuführen;
- wobei der Hüllkurvendetektor (GP2) die ersten Einstellmittel (OP2; R6, V2ref) angeordnet zum Nichtüberschreiten eines festen Vorverzerrungswertes an der Regelspannung (VP) entsprechend dem festen Wert von Phasenvorverzerrung (A) umfaßt.

10. Analog-Vorverzerrungslinearisierer des vorhergehenden Anspruchs, **dadurch gekennzeichnet, daß** der Amplitudenvorverzerrer (GP) und der Hüllkurvendetektor (GP2) jeweils einen FET (TR1, TR2) enthalten, subpolarisiert am Abschnürpunkt zum Erweitern der Verstärkung und Erhöhen des Vorspannungsstroms durch Selbstpolarisationswirkung bei steigendem Leistungspegel des entsprechenden Eingangssignals.

11. Analog-Vorverzerrungslinearisierer nach dem vorhergehenden Anspruch, **dadurch gekennzeichnet, daß** der FET eine viel höhere Grenzfrequenz als die Betriebsfrequenz aufweist.

12. Analoger Vorverzerrungslinearisierer nach einem beliebigen Anspruch von 8 bis 11, **dadurch gekennzeichnet, daß** das erste und zweite Einstellmittel jeweils einen Operationsverstärker, angeordnet innerhalb einer Rückkopplungskonfiguration zum Einstellen eines konstanten Durchschnitts-Vorspannungs-Drain-Stroms (Idss) des FETs nur in Abhängigkeit von einer einzelnen Bezugsspannung (Vref2, Vref1), angelegt an einen Eingang des Operationsverstärkers umfaßt, wobei die Bezugsspannung in einem weiten Bereich von Temperaturen stabil ist.

13. Analog-Vorverzerrungslinearisierer eines beliebigen Anspruchs von 10 bis 12, **dadurch gekennzeichnet, daß** ein regelbares Dämpfungsglied (ATT) in Kaskade mit dem Amplitudenvorverzerrer (GP) geschaltet ist, zum Einstellen einer Dämpfung in direkter Abhängigkeit von der unverzerrten Verstärkung des FETs.

14. Analog-Vorverzerrungslinearisierer des vorhergehenden Anspruchs, **dadurch gekennzeichnet, daß das** regelbare Dämpfungsglied (ATT) eine durch die direkte Komponente des Drain-Stroms des FETs gekreuzte Pindiode ist.

15. Analog-Vorverzerrungslinearisierer eines beliebigen Anspruchs von 8 bis 14, **dadurch gekennzeichnet, daß** er folgendes umfaßt:
- Mittel (WLK1) zum Aufspalten des Eingangssignals (ZFp) in eine Kopie von Signalen am Eingang von zwei Parallelzweigen, von denen ein erster den Amplitudenverzerrer (GP) und die entsprechenden Regelungs- und Einstellmittel umfaßt;
- einen linearen Leistungsverstärker (ZFAMP) entlang dem zweiten Zweig;
- Verzögerungsmittel (RESLINE) entlang dem zweiten Zweig zum Ausgleichen der Verzögerungen am Ausgang der zwei Zweige;
- Mittel (WLK2) zum Summieren der Signale am Ausgang der zwei Zweige, ergebend ein einmaliges vorverzerrtes Signal (ZFpa), das zum Leistungsverstärker (PTX) weitergeleitet wird.

16. Analog-Vorverzerrungslinearisierer des vorhergehenden Anspruchs, **dadurch gekennzeichnet, daß** die Verzögerungsmittel (RESLINE) durch eine als Dämpfungsglied zum Verändern des Signalpegels auf dem Parallelzweig wirkende ohmsche Leitung gebildet sind.

17. Analog-Vorverzerrungslinearisierer nach Anspruch 15, **dadurch gekennzeichnet, daß** zum Verändern des Signalpegels auf dem Parallelzweig ein Dämpfungsglied in Reihe mit dem Verzögerungsmittel (RESLINE) geschaltet ist.

## Revendications

1. Procédé pour linéariser la caractéristique de transfert entrée-sortie d'un amplificateur de puissance de signaux (PTX) affecté d'une distorsion d'amplitude et/ou de phase aux niveaux de puissance supérieurs du signal de sortie, en introduisant sur le signal à amplifier une pré-distorsion analogique de la phase (PP) et de l'amplitude (GP) avec une tendance opposée par rapport à ladite distorsion imprimée par l'amplificateur de puissance, **caractérisé en ce qu'**il inclut les étapes de :
- régler une valeur fixe de pré-distorsion de phase maximum (A) à partir d'un niveau de puissance maximum (C) fixé a priori des produits d'intermodulation intrabande introduits par les pré-distorsions à la fois de phase et d'amplitude ;
- régler une valeur fixe de pré-distorsion d'amplitude maximum (B) comme dans l'étape précédente ;
- effectuer une pré-distorsion de phase jusqu'à la mesure du réglage correspondant ;
- effectuer une pré-distorsion d'amplitude jusqu'à la mesure du réglage correspondant.

2. Procédé selon la revendication 1, **caractérisé en ce que** ledit niveau de puissance maximum (C) fixé a priori des produits d'intermodulation intrabande est divisé en deux contributeurs correspondant respectivement à ladite valeur fixe de pré-distorsion de phase (A) et de pré-distorsion d'amplitude (B) maximum.

3. Procédé selon la revendication 2, **caractérisé en ce que** lesdits contributeurs sont égaux.

4. Procédé selon la revendication 2, **caractérisé en ce que** lesdits contributeurs sont choisis de manière à correspondre à la distorsion de signature de l'amplificateur de puissance (PTX).

5. Procédé selon l'une quelconque des revendications précédentes, **caractérisé en ce que** le signal amplifié par ledit amplificateur de puissance (PTX) est un signal de bande de base généré par un transducteur, par exemple un microphone.

6. Procédé selon l'une quelconque des revendications précédentes à l'exception de la 5, **caractérisé en ce que** le signal amplifié par ledit amplificateur de puissance (PTX) est une porteuse de radiofréquence modulée (RF), par exemple un signal M-QAM avec un rapport de puissance de crête/moyenne donné dépendant de M.

7. Procédé selon la revendication 6, **caractérisé en ce que** le signal de fréquence intermédiaire (IF) est pré-distordu à l'intérieur (IDU) et transporté vers un étage de conversion de radiofréquence et d'amplification de puissance situé à l'extérieur (ODU) par l'intermédiaire d'une connexion physique.

8. Linéarisateur à pré-distorsion analogique (LIN) destiné à être connecté en amont d'un amplificateur de puissance (PTX) affecté d'une compression de gain et d'une distorsion de phase aux niveaux de puissance supérieurs du signal de sortie (RF), incluant un pré-distordeur de phase (PP) et un pré-distordeur d'amplitude (GP) commandés de manière à introduire des pré-distorsions de phase et d'amplitude aux niveaux de puissance supérieurs du signal d'entrée (IN, IF) avec des directions opposées par rapport à celles introduites par l'amplificateur de puissance (OUT, RF), **caractérisé en ce que :**
- le pré-distordeur de phase (PP) est placé en amont du pré-distordeur d'amplitude (GP) ;
- le pré-distordeur de phase (PP) inclut un premier moyen de réglage (OP2, R6, V2ref) agencé de manière à régler une valeur fixe de pré-distorsion de phase maximum (A) sur le signal (IFp) acheminé vers le pré-distordeur d'amplitude (GP) ;
- le pré-distordeur d'amplitude (GP) inclut un deuxième moyen de réglage (OP1, R3, V1ref) agencé de manière à régler une valeur fixe de pré-distorsion d'amplitude maximum (B) sur le signal (IFpa) acheminé vers l'amplificateur de puissance (PTX) ;
- le premier et le deuxième moyens de réglage sont tous les deux configurés (V2ref, V1ref) de manière à dériver leur réglage (A, B) d'un niveau de puissance maximum (C) fixé a priori des produits d'intermodulation intrabande introduits par les pré-distordeurs à la fois de phase et d'amplitude (PP, GP).

9. Linéarisateur à pré-distorsion analogique selon la revendication 8, **caractérisé en ce que** le moyen de commande dudit pré-distordeur de phase (PP) inclut :
- un déphaseur à tension asservie (SFAS) ;
- un détecteur d'enveloppe (GP2) pour délivrer en sortie la tension de commande (VP) pour le déphaseur (SFAS) lui-même commandé par ledit signal d'entrée bas niveau (IN, IF) de manière à introduire une tension de commande (VP) distordue avec une direction opposée par rapport à la distorsion de phase introduite par l'amplificateur de puissance (PTX) ;
- le détecteur d'enveloppe (GP2) inclut le premier moyen de réglage (OP2, R6, V2ref) agencé pour ne pas dépasser une valeur fixe de pré-distorsion sur la tension de commande (VP) correspondant à ladite valeur fixe de pré-distorsion de phase (A).

10. Linéarisateur à pré-distorsion analogique selon la revendication précédente, **caractérisé en ce que** ledit pré-distordeur d'amplitude (GP) et ledit détecteur d'enveloppe (GP2) incluent chacun un FET (TR1, TR2) sous-polarisé à la tension de pincement de manière à étendre le gain et augmenter le courant de polarisation par effet d'auto-polarisation lorsque le niveau de puissance du signal d'entrée concerné augmente.

11. Linéarisateur à pré-distorsion analogique selon la revendication précédente, **caractérisé en ce que** ledit FET a une fréquence de coupure beaucoup plus élevée que la fréquence opérationnelle.

12. Linéarisateur à pré-distorsion analogique selon l'une quelconque des revendications 8 à 11, **caractérisé en ce que** lesdits premier et deuxième moyens de réglage incluent chacun un amplificateur opérationnel agencé au sein d'une configuration de rétroaction de manière à régler un courant de drain de polarisation moyen constant (Idss) dudit FET ne dépendant que d'une tension de référence individuelle (Vref2, Vref1) appliquée à une entrée de l'amplificateur opérationnel, ladite référence étant stable sur une large plage de températures.

13. Linéarisateur à pré-distorsion analogique selon l'une quelconque des revendications 10 à 12, **caractérisé en ce qu'**un atténuateur variable (ATT) est installé en cascade avec ledit pré-distordeur d'amplitude (GP) pour régler une atténuation dépendant directement du gain non distordu du FET.

14. Linéarisateur à pré-distorsion analogique selon la revendication précédente, **caractérisé en ce que** l'atténuateur variable (ATT) est une diode PIN traversée par la composante directe du courant de drain du FET.

15. Linéarisateur à pré-distorsion analogique selon l'une quelconque des revendications 8 à 14, **caractérisé en ce qu'**il inclut :
- un moyen (WLK1) pour partager le signal d'entrée (IFp) en une copie de signaux à l'entrée de deux branches parallèles, une première desquelles incluant ledit pré-distordeur d'amplitude (GP) et les moyens concernés de commande et de réglage ;
- un amplificateur de puissance linéaire (IFAMP) sur la deuxième branche ;
- un moyen de retard (RESLINE) sur la deuxième branche pour égaliser les retards à la sortie des deux branches ;
- un moyen (WLK2) pour sommer les signaux à la sortie des deux branches, obtenant un signal pré-distordu unique (IFpa) acheminé vers l'amplificateur de puissance (PTX).

16. Linéarisateur à pré-distorsion analogique selon la revendication précédente, **caractérisé en ce que** ledit moyen de retard (RESLINE) est constitué par une ligne résistive agissant comme atténuateur pour faire varier le niveau de signal sur la branche parallèle.

17. Linéarisateur à pré-distorsion analogique selon la revendication 15, **caractérisé en ce qu'**un atténuateur est connecté en série audit moyen de retard (RESLINE) pour faire varier le niveau de signal sur la branche parallèle.
